# EUROPEAN PATENT SPECIFICATION

(11) **EP 3 350 829 B1**
(45) Date of publication and mention of the grant of the patent: **02.12.2026**
(21) Application number: 16847008.6
(22) Date of filing: 03.08.2016
(51) Int. Cl.: H10W 72/00, H10W 72/20, H10W 72/90, H10W 99/00, H10W 72/29, H10W 95/00

(54) **METHODS FOR COLLARS FOR UNDER-BUMP METAL STRUCTURES**
VERFAHREN FÜR KRAGEN FÜR UNDER-BUMP-METALLSTRUKTUREN
PROCÉDÉS POUR COLLIERS POUR STRUCTURES DE MÉTALLISATION SOUS BOSSE

(30) Priority: 14.09.2015 US 201514853807
(43) Date of publication of application: 25.07.2018
(73) Proprietor: Micron Technology, Inc., Boise, ID 83707-0006 (US)
(72) Inventor: MARIOTTINI, Giorgio, Boise, ID 83709 (US); VADHAVKAR, Sameer, Boise, ID 85233 (US); HUANG, Wayne, Boise, ID 83709 (US); CHANDOLU, Anilkumar, Boise, ID 83716 (US); BOSSLER, Mark, Meridian, ID 83642 (US)
(74) Representative: Carpmaels & Ransford LLP
(86) International application number: PCT/US2016/045255
(87) International publication number: WO 2017/048388

(56) References cited:
- JP-A- 2009 231 682
- US-A1- 2002 185 733
- US-A1- 2009 149 016
- US-A1- 2011 068 437
- US-A1- 2011 266 667
- US-A1- 2013 087 908
- US-A1- 2013 299 972
- US-A1- 2014 077 367
- US-A1- 2014 363 970

## Description

### TECHNICAL FIELD

The present technology is directed generally to semiconductor devices, and in several embodiments more particularly to under-bump metal (UBM) structures for die-to-die and/or package-to-package interconnects.

### BACKGROUND

Microelectronic devices, such as memory devices, microprocessors, and light emitting diodes, typically include one or more semiconductor dies mounted to a substrate and encased in a plastic protective covering. Semiconductor dies include functional features, such as memory cells, processor circuits, and interconnecting circuitry. Semiconductor dies also typically include bond pads electrically coupled to the functional features. The bond pads are electrically connected to pins or other types of terminals that extend outside the protective covering for connecting the semiconductor die to busses, circuits, or other assemblies.

Semiconductor die manufacturers are under increasing pressure to reduce the volume occupied by the die and yet increase the capacity and/or speed of the resulting encapsulated assemblies. To meet these demands, semiconductor die manufacturers often stack multiple dies on top of each other to increase the capacity or performance of the device within the limited volume on the circuit board or other element to which the dies are mounted. In many applications, the dies are stacked on each other before being encapsulated to form a three-dimensional package.

The stacked semiconductor dies are typically electrically connected by solder bumps or other electrical connectors that are attached to under-bump metal (UBM) structures. The UBM structures are typically formed by depositing a copper seed structure onto a wafer, forming a mask on the copper seed structure having openings aligned with bond pads on the die, plating copper onto the seed structure, and then plating one or more other materials over the copper to form UBM structures. The top-most material of the UBM structure is typically selected to promote wetting for subsequently forming interconnects on the top-most material. After forming the UBM structures, microbumps of solder material are formed over the top-most material of the UBM structures to serve as interconnects. After forming the UBM structures and microbumps, the mask is removed and the exposed portions of the seed structure are removed using a suitable wet etch to form isolated UBM structures and microbumps. The present technology is directed to improved UBM structures and methods of manufacturing UBM structures.
US2009/149016 A1 describes a semiconductor device and a method of fabricating the same. The method of fabricating the semiconductor device includes forming a mask pattern having an opening corresponding to an electrode pad formed on a semiconductor substrate; forming a bump by filling the opening with a conductive first material; forming a sidewall film on sidewalls of the bump using a second material; forming a connection member between an upper surface of the bump and a wire substrate using a conductive third material in order to electrically connect the bump and the wire substrate; and forming an underfill resin between the wire substrate and the semiconductor substrate, wherein a wetting angle between the second material and the third material is greater than that between the first material and the third material.

US2011/266667 A1 describes a sidewall protection structure for covering at least a portion of a sidewall surface of a bump structure, in which a protection structure on the sidewalls of a Cu pillar and a surface region of an under-bump-metallurgy (UBM) layer is formed of at least one non-metal material layers, for example a dielectric material layer, a polymer material layer, or combinations thereof.

### BRIEF DESCRIPTION OF THE DRAWINGS

Many aspects of the present technology can be better understood with reference to the following drawings. The components in the drawings are not necessarily to scale, but instead emphasis is placed on clearly illustrating the principles of the present technology.
Figure 1 is a cross-sectional view of a substrate assembly schematically showing a plurality of semiconductor dies in accordance with an embodiment of the claimed invention.
Figures 2A-2H are cross-sectional views schematically illustrating a portion of a semiconductor die at various stages of a method in accordance with an embodiment of the claimed invention.
Figures 3A-3G are cross-sectional views schematically illustrating a portion of a semiconductor die at various stages of a method in accordance with another embodiment of the claimed invention.
Figure 4 is a flow chart of a method in accordance with an embodiment of the claimed invention.
Figure 5 is a flow chart of a method in accordance with an embodiment of the claimed invention.
Figure 6 is a block diagram illustrating a system that incorporates a semiconductor device in accordance with an embodiment of the present technology.

### DETAILED DESCRIPTION

The invention is defined by the methods according to the appended independent claims 1 and 5. Further embodiments are defined in the dependent claims. Specific details of several embodiments of methods for making semiconductor devices are described herein along with related devices and systems. The term "semiconductor device" generally refers to a solid-state device that includes one or more semiconductor materials. Examples of semiconductor devices include logic devices, memory devices, microprocessors, and diodes among others. Furthermore, the term "semiconductor device" can refer to a finished device or to an assembly or other structure at various stages of processing before becoming a finished device. Depending upon the context in which it is used, the term "substrate" can refer to a wafer-level substrate or to a singulated, die-level substrate. A person having ordinary skill in the relevant art will recognize that suitable steps of the methods described herein can be performed at the wafer level or at the die level. Furthermore, unless the context indicates otherwise, structures disclosed herein can be formed using conventional semiconductor-manufacturing techniques. Materials can be deposited, for example, using chemical vapor deposition, physical vapor deposition, atomic layer deposition, spin coating, and/or other suitable techniques. Similarly, materials can be removed, for example, using plasma etching, wet etching, chemical-mechanical planarization, or other suitable techniques.

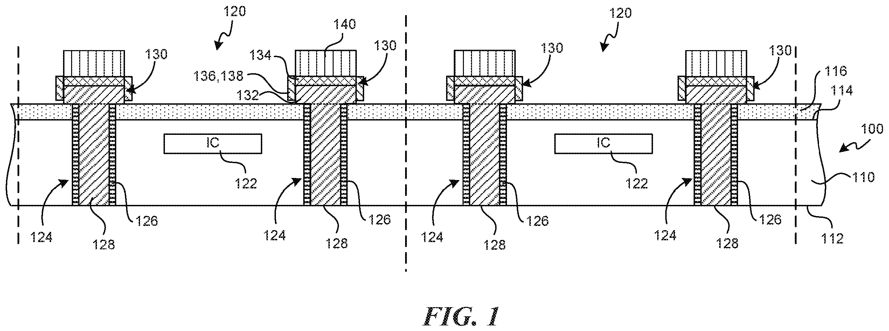

Many embodiments of the present technology are described below in the context of UBM structures that are electrically coupled to TSVs, such as through-silicon vias that have electrically conductive plugs or connectors which extend completely through the substrate and/or packaging material when completed. A person having ordinary skill in the relevant art will also understand that the present technology may include embodiments for forming UBM structures on either the first side or the second side of a substrate assembly, and the UBM structures may be used in the context of other electrical connectors associated with a semiconductor assembly. The present technology may accordingly be practiced without several of the details of the embodiments described herein with reference to Figures 1-6. For ease of reference, identical reference numbers are used to identify similar or analogous components or features throughout this disclosure, but the use of the same reference number does not imply that the features should be construed to be identical. Indeed, in many examples described herein, identically numbered features have a plurality of embodiments that are distinct in structure and/or function from each other. Furthermore, the same shading may be used to indicate materials in cross section that can be compositionally similar, but the use of the same shading does not imply that the materials should be construed to be identical unless specifically noted herein.

UBM structures and microbumps are attached to an adjacent die using reflow processes. During reflow of a microbump disposed on top of a UBM structure, some material of the microbump (e.g., tin) may react with material of the UBM structure (e.g., copper), which can deleteriously affect the interconnection between the UBM structure and the adjacent die. For example, some of the material from the microbump can out-flow due to sidewall wetting along the UBM structure. This can lead to formation of an intermetallic compound on the microbump sidewall. Additionally, some of the microbump material (e.g., tin) can diffuse until reaching and reacting with the UBM structure material (e.g., copper), resulting in molar volume shrinkage for the available tin in the microbump, also referred to as solder starvation. These two effects can result in depletion of un-reacted solder material available at the center of the microbump, causing voids in the solder joint and reducing the electromigration reliability.

Several embodiments of the present technology significantly reduce the possibility for solder material of a microbump to react with material of a UBM structure during reflow of the microbump. For example, several embodiments of the present technology form a collar around at least a portion of the first material and/or the second material of the UBM structure that protects the UBM sidewalls from reacting with solder from the microbump. Several embodiments of the present technology accordingly reduce the reaction between the microbumps and UBM sidewalls during microbump reflow as explained in more detail below.

Figure 1 is a cross-sectional view that schematically illustrates a substrate assembly 100 having a semiconductor material 110 with a first side 112 and a second side 114. The substrate assembly 100 further includes a dielectric material 116 on the second side 114 of the semiconductor material 110. A plurality of semiconductor dies 120 are formed at discrete areas of the substrate assembly 100. Although two semiconductor dies 120 are illustrated in Figure 1, in practice the semiconductor assembly 100 typically has several hundred or even over 1,000 individual semiconductor dies. The individual semiconductor dies 120 can include integrated circuitry 122 and a plurality of interconnects 124 electrically coupled to the integrated circuitry 122. In the embodiment shown in Figure 1, the interconnects 124 are TSVs that include a dielectric liner 126 and a conductive plug 128 within the dielectric liner 126. The interconnects 124 can accordingly extend completely through the substrate assembly 100.

The semiconductor dies 120 further include a plurality of UBM structures 130, and individual UBM structures 130 are electrically coupled to corresponding interconnects 124. In accordance with the claimed invention, the individual UBM structures 130 comprise a first material 132 electrically coupled to one of the interconnects 124 and a second material 134 over the first material 132. An anti-wetting material 136 forms a collar 138 around at least a portion of the first material 132 and the second material 134. The semiconductor dies 120 also includes microbumps 140 over the second material 134 of individual UBM structures 130.

In a particular embodiment, the first material 132 comprises copper, the second material 134 comprises nickel, the microbump 140 comprises a tin-silver solder material, and the collar 138 comprises an oxide, for example tetraethyl orthosilicate (TEOS) or another oxide. This embodiment forms a Cu/Ni UBM structure 130 with a microbump 140 formed thereover and an oxide collar surrounding the exposed sidewall of the Ni and a portion of the Cu without covering the top surface of the UBM structure 130 (e.g., the top surface of the second material 134). In other embodiments, the first and second materials 132 and 134 can comprise any electrically conductive material, for example, gold, silicon, tungsten, etc. The shape and dimension of the UBM structure 130 can vary. For example, in some embodiments, the UBM structure 130 is substantially cylindrical, forming a pillar-like structure, but the UBM structure 130 can have other cross-sectional shapes in other embodiments, for example rectangular, regular polygonal, irregular polygonal, elliptical, etc. The UBM structure 130 can have a thickness of between about 1-100 microns and can have a height of between about 1-100 microns.

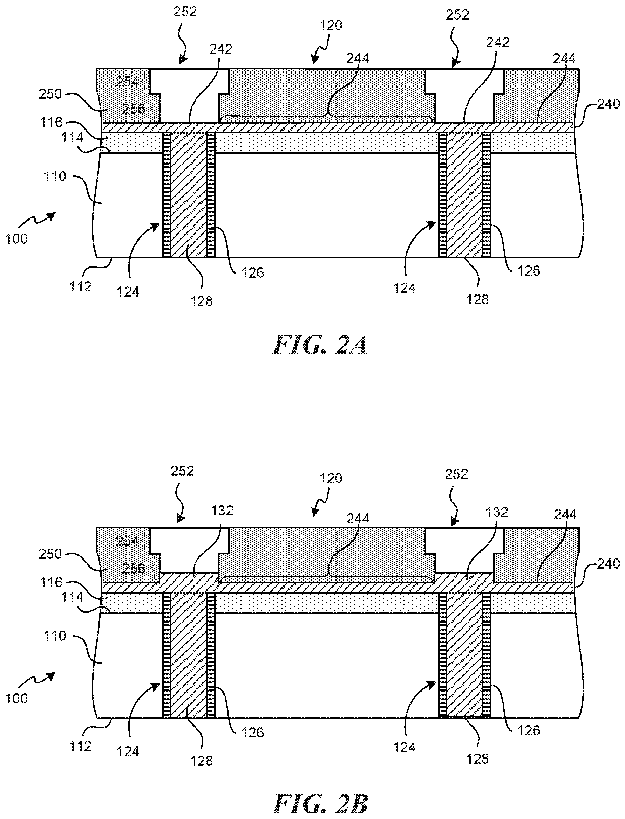

The microbump 140 comprises a solder material, for example tin-silver, indium, or another suitable solder material for forming an electrical and mechanical connection between the UBM structure 130 and an adjacent die. The anti-wetting material 136 forming the collar 138 comprises, in accordance with the claimed invention, a material that prevents wetting of the microbump 140 on the sidewall of the first and second materials 132 and 134 (e.g., the anti-wetting material 136 provides a non-wettable surface for the material of the microbump 140). The anti-wetting material 136 has a diffusability for the solder material of the microbump 140 that is extremely low or negligible. For example, in some embodiments, the anti-wetting material 136 comprises an oxide, a nitride, or polyimide. In some embodiments, the anti-wetting material 136 has a thickness of between about 1000-5000 Å, or in some embodiments between about 2000-2500 Å. In several embodiments, the anti-wetting material 136 completely surrounds at least a portion of the circumference of the first and/or second materials 132 and 134, but in other embodiments the anti-wetting material 136 covers less than the full circumference. According to the claimed invention, the anti-wetting material 136 also extends along a portion of the height of the UBM structure 130; for example the anti-wetting material 136 covers at least 80% of the height of the UBM structure 130. The collar 138 comprising the anti-wetting material 136 eliminates or reduces wetting of solder from the microbump 140 along the sidewall of the first and second material 132 and 134 of the UBM structure 130. Further embodiments and aspects of forming UBM structures, collars, and microbumps in accordance with the present technology are described below with reference to Figures 2A-3G.

Figures 2A-2H are cross-sectional views schematically illustrating a semiconductor die 120 at a portion of the substrate assembly 100 during different stages of a method for forming UBM structures, collars, and microbumps, in accordance with the claimed invention. Referring to Figure 2A, at this stage of the method the semiconductor die 120 has a seed structure 240 formed on the dielectric material 116 and the portions of the interconnects 124 proximate to the second side 114 of the substrate 110, and a mask 250 on the seed structure 240. The seed structure 240 can have first areas 242 associated with the location of the interconnects 124 and second areas 244 between the first areas 242. The seed structure 240 can be a single material suitable for plating the base or first material of a UBM structure. In several embodiments, the seed structure 240 includes a barrier material and a seed material on the barrier material. The barrier material can be tantalum, tantalum nitride, titanium, titanium-tungsten or another material that prevents diffusion of the UBM materials into the dielectric material 116 and the substrate 102. The seed material can be copper, a copper alloy, nickel, or other suitable materials for plating the first material 132 (Figure 1) onto the seed material using electro-plating or electroless-plating techniques known in the art. In practice the seed structure 240 can integrate with the conductive plug 128 of the interconnect 124.

The mask 250 can be a resist material or other suitable mask material having a plurality of openings 252 aligned with the first areas 242 of the seed structure 240. As explained in more detail below, UBM structures are formed in the openings 252 of the mask 250. The openings 252 of the mask 250 have a T-shaped cross-section when viewed from the sides as shown in Figure 2A, in which an upper portion 254 has a wider opening than a lower portion 256. This T-shaped opening 252 in the mask 250 can be formed using a leaky chrome mask during photolithography or other suitable technique.

Figure 2B is a cross-sectional view schematically illustrating the semiconductor die 120 after the first material 132 has been formed on the exposed first area 242 (Figure 2A) of the seed structure 240. In one embodiment, the seed structure 240 includes a copper seed material deposited using a physical vapor deposition process, and the first material 132 comprises copper deposited onto the copper seed material using an electro-plating or electroless-plating process known in the art. The first material 132 can accordingly define a base material of the UBM structure. In one embodiment, the first material 132 has a first diameter (e.g., 30 µm) and a height (30 µm) at this stage of the process, but the diameter and the height of the first material 132 can have any other suitable dimension according to the specific configuration of the particular semiconductor die 120.

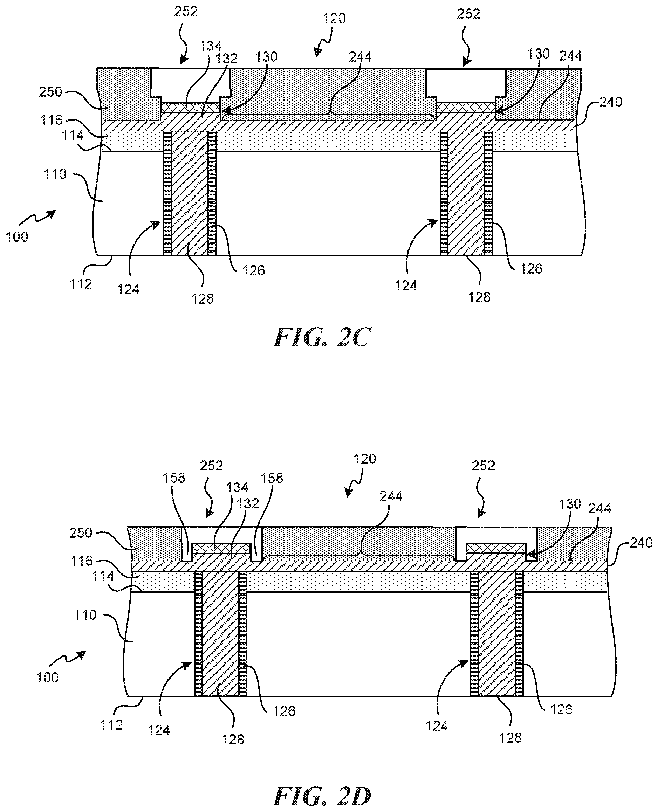

Figure 2C is a cross-sectional view schematically illustrating the semiconductor die 120 after the second material 134 has been deposited into the openings 252 such that the second material 134 is over the first material 132. The second material 134 can comprise nickel or other suitable materials that provide a good wetting surface for forming interconnects on the second material 134. The first material 132 and second material 134 can define a UBM structure 130. At this stage of the process, the semiconductor die 120 has a plurality of UBM structures 130 that are electrically coupled to each other through the seed structure 240. In some examples not falling within the scope of the claimed invention but useful for the understanding thereof, the second material can be omitted altogether, and the UBM structure can include only the first material.

Figure 2D is a cross-sectional view schematically illustrating the semiconductor die 120 after a portion of the mask 250 has been removed to define collar openings 258 in accordance with one embodiment of the present technology. The mask 250 can be etched using an anisotropic dry etch and dry clean. The dry etch can remove the mask 250 substantially uniformly across the semiconductor die 120 until it is completely removed in the collar openings 258 adjacent the UBM structures 130. The collar openings 258 can define a thickness of the collars 138 (Figure 1), for example having a thickness of between about 1000-5000 Å, or between about 2000-2500 Å. The parameters of the dry etch (e.g., chemistry, power, temperature, etc.) can be tailored in order to harden the mask 250 during the etch to prepare the mask 250 for subsequent deposition steps.

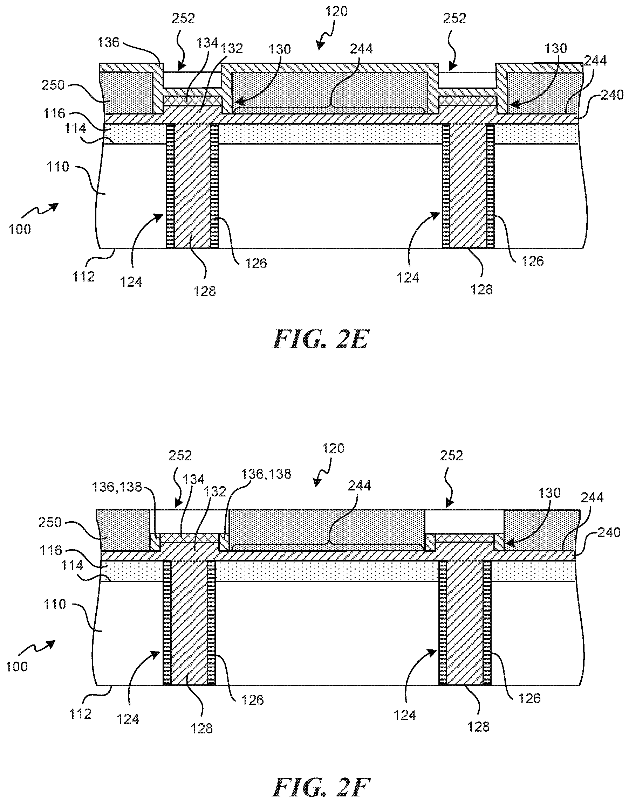

Figure 2E is a cross-sectional view schematically illustrating the semiconductor die 120 after the anti-wetting material 136 has been formed in accordance with one embodiment of the present technology. The anti-wetting material 136 is a material to which the solder material of the microbump 140 (Figure 1) does not readily wet (e.g., cover) in liquid phase and/or has low or negligible diffusability for the solder material of the microbump 140 (Figure 1). The anti-wetting material 136 can be an oxide, a nitride, polyimide, or other suitable material. In one embodiment, the anti-wetting material 136 is tetraethyl orthosilicate (TEOS) formed by low-temperature (e.g., less than 150° C) plasma-enhanced chemical vapor deposition or other suitable process. The anti-wetting material 136 is formed as a blanket layer over the mask 250 and the openings 252, including covering the UBM structures 130 and filling the collar openings 258 (Figure 2D).

Figure 2F is a cross-sectional view schematically illustrating the semiconductor die 120 after portions of the anti-wetting material 136 have been removed in accordance with one embodiment of the technology. A buffered oxide etch or a spacer etch followed by a wet clean can be used to remove portions of the anti-wetting material 136. As shown in Figure 2F, most of the anti-wetting material 136 has been removed until the only remaining portions of the anti-wetting material 136 are in the collar openings 258 (Figure 2D) to form the collars 138. In some embodiments, the collars 138 can be substantially coplanar with the second material 134, while in other embodiments the collars 138 can be recessed with respect to the second material 134.

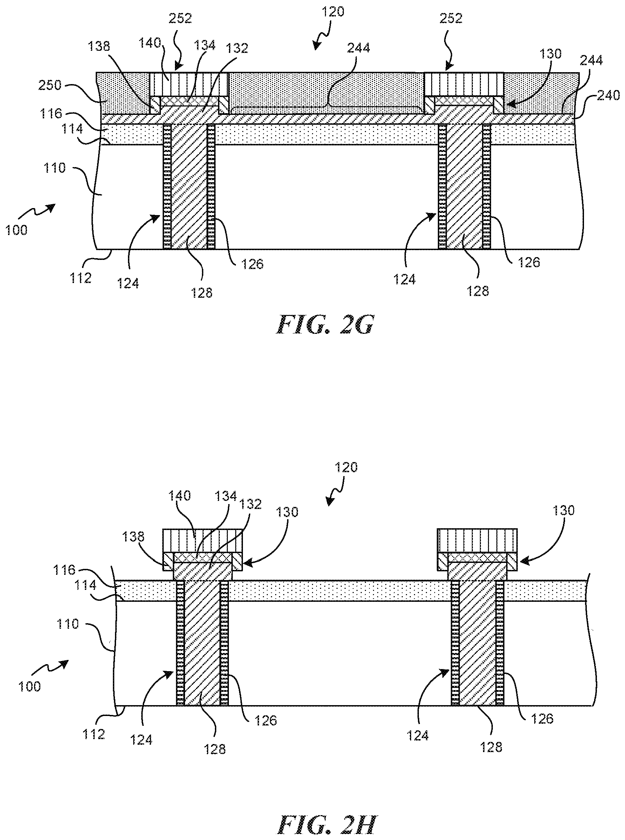

Figure 2G is a cross-sectional view schematically illustrating the semiconductor die 120 after the microbumps 140 have been formed in accordance with one embodiment of the claimed invention. The microbumps 140 are formed of solder material, for example tin-silver or indium solder, which is plated into the openings 252 on top of the UBM structure 130 and the collar 138. In some embodiments, the microbumps 140 can have a height of between about 3-50 microns.

Figure 2H is a cross-sectional view schematically illustrating the semiconductor die 120 after the mask 250 and portions of the seed structure 240 are removed to electrically isolate the UBM structures 130. The mask 250 can be removed using a wet photoresist strip or other suitable technique, and then the second areas 244 of the seed structure 240 are removed using a wet etch suitable for removing the materials of the seed structure. At this point, the UBM structures are electrically isolated from each other.

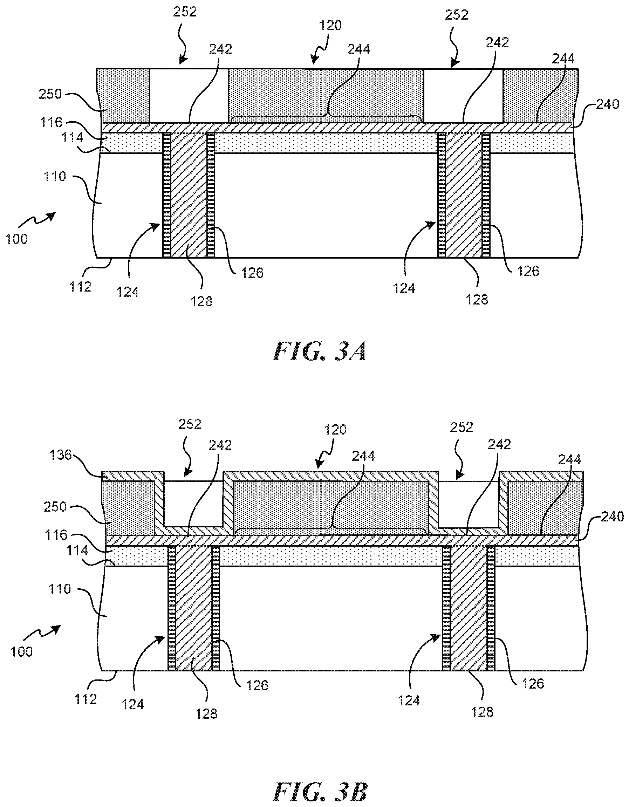

Figures 3A-3G are cross-sectional views schematically illustrating a semiconductor die 120 at a portion of the substrate assembly 100 during different stages of manufacturing UBM structures, collars, and microbumps in accordance with another embodiment, accordance with the claimed invention. Referring to Figure 3A, at this stage of the method the semiconductor die 120 has the seed structure 240 on the dielectric material 116 and the portions of the interconnects 124 proximate to the second side 114 of the substrate 110, and the mask 250 is on the seed structure 240. The seed structure 240 has first areas 242 associated with the location of the interconnects 124 and second areas 244 between the first areas 242. The mask 250 can be a resist material or other suitable mask material having a plurality of openings 252 aligned with the first areas 242 of the seed structure 240. As explained in more detail below, UBM structures are formed in the openings 252 of the mask 250.

Figure 3B is a cross-sectional view schematically illustrating the semiconductor die 120 after the anti-wetting material 136 has been formed in accordance with one embodiment of the claimed invention. The anti-wetting material 136 is a material to which the solder material of the microbump 140 (Figure 1) does not readily wet (e.g., cover) in liquid phase and/or has low or negligible diffusability for the solder material of the microbump 140 (Figure 1). The anti-wetting material 136 can be an oxide (e.g., tetraethyl orthosilicate (TEOS) or other oxide), a nitride, polyimide, or other suitable material. In one embodiment, the anti-wetting material 136 is tetraethyl orthosilicate (TEOS) formed by low-temperature (e.g., less than 150° C) plasma-enhanced chemical vapor deposition or other suitable process. The anti-wetting material 136 is formed as a blanket layer over the mask 250 and the openings 252.

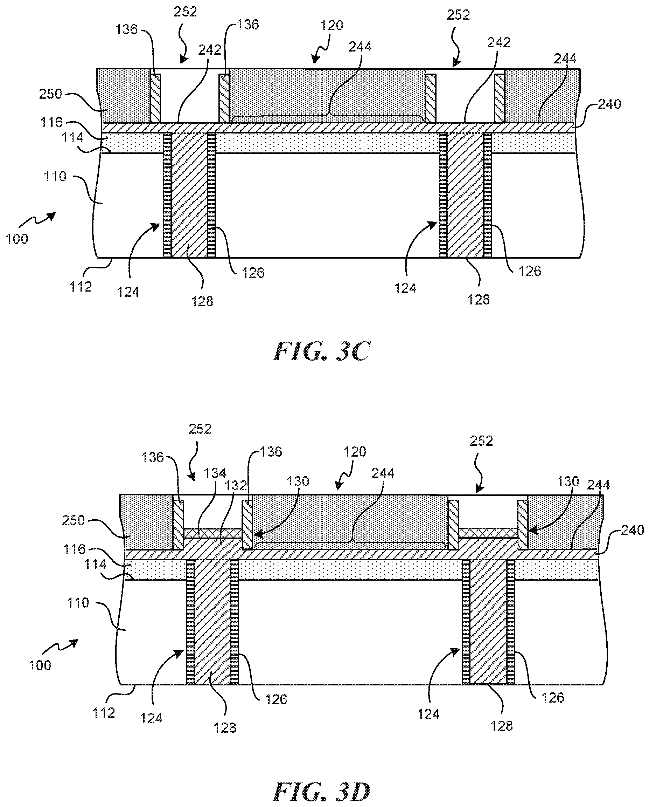

Figure 3C is a cross-sectional view schematically illustrating the semiconductor die 120 after portions of the anti-wetting material 136 have been removed in accordance with one embodiment of the technology. A spacer oxide etch followed by a wet clean can be used to remove portions of the anti-wetting material 136. As shown in Figure 3C, the overlying portions of the anti-wetting material 136 have been removed until the only remaining portions of the anti-wetting material 136 are along sidewalls of the openings 152.

Figure 3D is a cross-sectional view schematically illustrating the semiconductor die 120 after the first material 132 has been formed on the exposed first areas 242 (Figure 3C) of the seed structure 240 and the second material 134 has been formed over the first material 132. In one embodiment, the seed structure 240 includes a copper seed material deposited using a physical vapor deposition process, and the first material 132 comprises copper deposited onto the copper seed material using an electro-plating or electroless-plating process known in the art. The first material 132 and second material 134 can define a UBM structure 130 surrounded by the anti-wetting material 136. At this stage of the process, the semiconductor die 120 has a plurality of UBM structures 130 that are electrically coupled to each other through the seed structure 240. In some examples not falling within the scope of the claimed invention but useful for the understanding thereof, the second material can be omitted altogether, and the UBM structure can include only the first material.

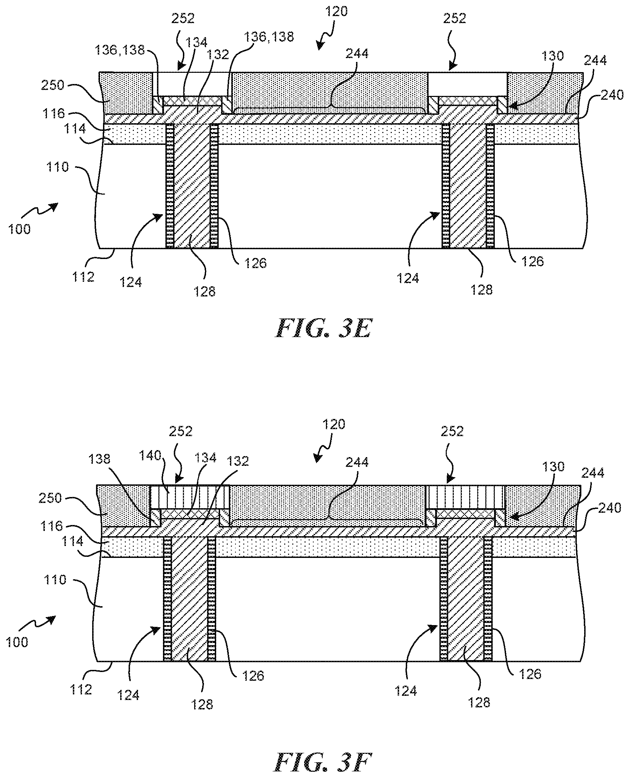

Figure 3E is a cross-sectional view schematically illustrating the semiconductor die 120 after further portions of the anti-wetting material 136 have been removed to form the collars 138. Similar to the process described above with respect to Figure 3B, the additional portions of the anti-wetting material 136 can be removed using a spacer oxide etch followed by a wet clean. As shown in Figure 3E, the anti-wetting material 136 has been removed until the only remaining anti-wetting material 136 along sidewalls of the openings 152 is substantially coplanar with the second material 134 and thereby forms the collar 138.

Figure 3F is a cross-sectional view schematically illustrating the semiconductor die 120 after the microbumps 140 have been formed. The microbumps 140 are formed of solder material, for example tin-silver or indium solder, which is plated into the openings 252 on top of the UBM structure 130 and the collar 138. In some embodiments, the microbumps 140 can have a height of between about 3-50 microns.

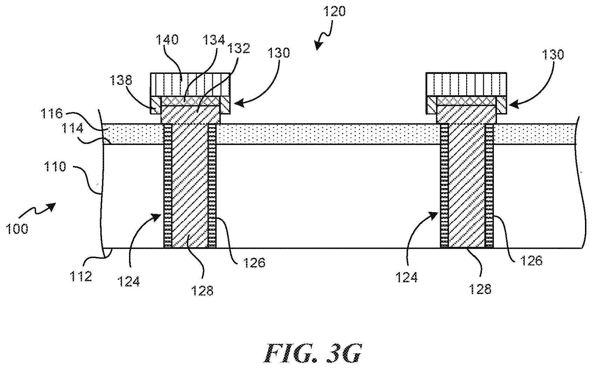

Figure 3G is a cross-sectional view schematically illustrating the semiconductor die 120 after the mask 250 and seed structure 240 are removed to electrically isolate the UBM structures 130. The mask 250 can be removed using a wet photoresist strip or other suitable technique, and then the second areas 244 of the seed structure 240 are removed using a suitable wet etch to electrically isolate the UBM structures 130 from each other.

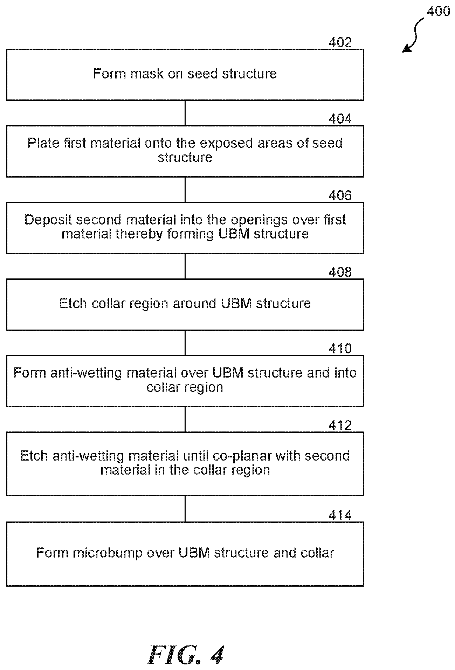

Figure 4 is a flow chart of an embodiment of a method 400 for forming UBM structures on a semiconductor die in accordance with an embodiment of the present technology. In this embodiment, the method 400 includes forming a mask on a seed structure (block 402) and plating a first material onto the exposed areas of the seed structure (block 404). The mask, has openings that expose areas of the seed structure which are electrically coupled to interconnects that extend at least partially through a semiconductor substrate. In several embodiments, the openings of the mask are superimposed over TSVs. The method 400 further includes depositing a second material into the openings over the first material thereby forming a UBM structure (block 406), and etching a collar region around the UBM structure (block 408). The method continues by forming an anti-wetting material over the UBM structure and into the collar region (block 410), followed by etching the anti-wetting material until it is substantially co-planar with the second material in the collar region (block 412). This step forms a collar surrounding the UBM structure. The method 400 continues by forming a microbump over the UBM structure (block 414). The mask is then removed, followed by removal of the exposed portions of the seed structure between the UBM structures by wet etching.

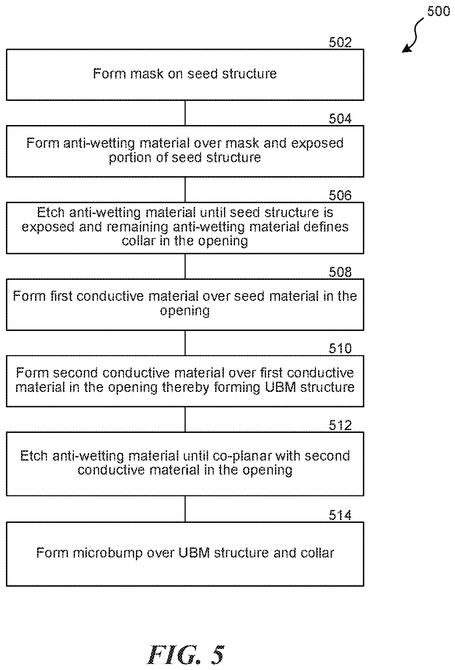

Figure 5 is a flow chart of an embodiment of a method 500 for forming UBM structures on a semiconductor die in accordance with an embodiment of the present technology. In this embodiment, the method 500 includes forming a mask on a seed structure (block 502) and forming an anti-wetting material over the mask and the exposed portions of the seed material (block 504). The mask, for example, has openings that expose areas of the seed structure which are electrically coupled to interconnects that extend at least partially through a semiconductor substrate. In several embodiments, the openings of the mask are superimposed over TSVs. The method 500 further includes etching the anti-wetting material until the seed structure is exposed and the remaining anti-wetting material defines a collar in the openings (block 506). For example, the anti-wetting material can be etched using a buffered oxide etch or a spacer etch followed by a wet clean. The method 500 continues by plating a first material over the seed material in the opening (block 508) and forming a second conductive material over the first conductive material in the opening, thereby forming a UBM structure (block 510). The method 500 then removes the anti-wetting material until the collar is substantially coplanar with the second conductive material in the opening (block 512). The method 500 continues by forming a microbump over the UBM structure (block 514). The mask is then removed, followed by removal of the exposed portions of the seed structure between the UBM structures by wet etching.

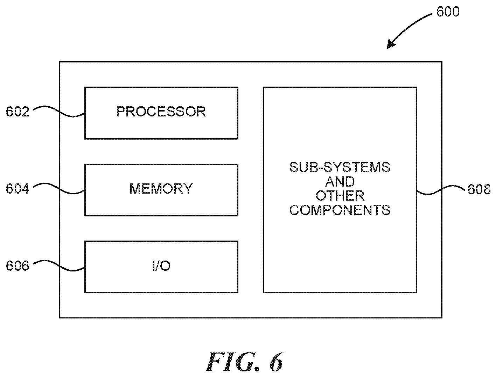

Any one of the semiconductor devices having the features described above with reference to Figures 1-5 can be incorporated into any of a myriad of larger and/or more complex systems, a representative example of which is system 600 shown schematically in Figure 6. The system 600 can include a processor 602, a memory 604 (e.g., SRAM, DRAM, flash, and/or other memory devices), input/output devices 606, and/or other subsystems or components 608. The semiconductor device 100 described above with reference to Figures 1-5 can be included in any of the elements shown in Figure 6. The resulting system 600 can be configured to perform any of a wide variety of suitable computing, processing, storage, sensing, imaging, and/or other functions. Accordingly, representative examples of the system 600 include, without limitation, computers and/or other data processors, such as desktop computers, laptop computers, Internet appliances, hand-held devices (e.g., palm-top computers, wearable computers, cellular or mobile phones, personal digital assistants, music players, etc.), tablets, multi-processor systems, processor-based or programmable consumer electronics, network computers, and minicomputers. Additional representative examples of the system 600 include lights, cameras, vehicles, etc. With regard to these and other example, the system 600 can be housed in a single unit or distributed over multiple interconnected units, e.g., through a communication network. The components of the system 600 can accordingly include local and/or remote memory storage devices and any of a wide variety of suitable computer-readable media.

From the foregoing, it will be appreciated that specific embodiments of the invention have been described herein for purposes of illustration, but that various modifications may be made without deviating from the scope of the invention. Accordingly, the invention is not limited except as by the appended claims.

## Claims

1. A method for manufacturing a semiconductor die (120), the semiconductor die comprising a semiconductor material (110) having solid-state components and an interconnect (124) extending at least partially through the semiconductor material;
the method comprising:
forming an under-bump metal, UBM, (130) structure,
the UBM structure comprising a seed structure (240), a first conductive material (132) and a second conductive material (134),
wherein forming the UBM structure
comprises:
forming a mask (250) on the seed structure, wherein the mask has an opening (252) that exposes an area of the seed structure that is electrically coupled to the interconnect; plating the first conductive material (132) onto the exposed area of the seed structure;
and depositing the second conductive material (134) into the opening over the first conductive material;
forming a collar (138) from an anti-wetting material, wherein the collar surrounds a portion of the full circumference of a sidewall of the UBM, structure without covering a top surface of the UBM structure and the collar extends along a portion of a height of the sidewall of the UBM structure;
disposing a solder material (140) on the top surface of the UBM structure,
wherein the solder material is plated into the opening (252) on top of the UBM structure (130) and the collar (138),
wherein the solder
material does not readily wet to the anti-wetting material when the solder material is in liquid phase;
removing at least a portion of the mask thereby exposing a portion of the seed structure; and
removing the exposed portion of the seed structure by wet etching.

2. The method of claim 1, wherein the anti-wetting material comprises at least one of: a nitride, an oxide, or polyimide.

3. The method of claim 1, wherein the opening (252) in the mask (250) has an upper portion and a lower portion, wherein the upper portion is wider than the lower portion,
the method further comprising:
plating the first conductive material (132) into the lower portion of the opening;
depositing the second conductive material (134) into the lower portion of the opening over the first conductive material thereby forming the UBM structure in the lower portion;
removing a portion of the mask to define a collar opening (158, 258) surrounding the UBM structure; and
forming the collar (138) comprising the anti-wetting material in the collar opening (158, 258).

4. The method of claim 3, wherein forming the collar (138) comprising the anti-wetting material in the collar opening (158, 258) comprises:
depositing a blanket layer of the anti-wetting material over the mask (250) and the opening (252); and
etching to remove a portion of the anti-wetting material while retaining the anti-wetting material in the collar opening.

5. A method for manufacturing a semiconductor die (120), the semiconductor die comprising a semiconductor material (110) having solid-state components and an interconnect (124) extending at least partially through the semiconductor material;
the method comprising:
forming a collar (138) from an anti-wetting material, wherein forming the collar comprises:
forming a mask (250) on a seed structure (240), wherein the mask has a first opening (252) that exposes an area of the seed structure that is electrically coupled to the interconnect; and
forming the collar over the exposed area of the seed structure, the collar defining a second opening;
forming an under-bump metal, UBM, (130) structure,
the UBM structure comprising the seed structure (240), a first conductive material (132) and a second conductive material (134),
wherein forming the UBM structure comprises plating the first conductive material (132) into the second opening and depositing the second conductive material (134) over the first conductive material,
wherein the collar surrounds a
portion of the full circumference of a sidewall of the UBM structure without covering a top surface of the UBM structure, and the collar extends along a portion of a height of the sidewall of the UBM structure;
disposing a solder material (140) on the top surface of the UBM structure,
wherein the solder material is plated into the opening (252) on top of the UBM structure (130) and the collar (138),
wherein the solder
material does not readily wet to the anti-wetting material when the solder material is in liquid phase;
removing at least a portion of the mask thereby exposing a portion of the seed structure; and
removing the exposed portion of the seed structure by wet etching.

6. The method of claim 5, wherein forming the collar (138) comprises:
depositing a blanket layer of the anti-wetting material over the mask (250) and the first opening (252), the
anti-wetting material coating interior side surfaces of the opening; and performing an anisotropic etch on the anti-wetting material to remove anti-wetting material from
a bottom surface of the first opening thereby forming the second opening.

## Patentansprüche

1. Verfahren zum Herstellen eines Halbleiterchips (120), wobei der Halbleiterchip ein Halbleitermaterial (110) mit Festkörperbauelementen und eine sich mindestens teilweise durch das Halbleitermaterial erstreckende Durchkontaktierung (124) umfasst;
wobei das Verfahren Folgendes umfasst:
Bilden einer Unterbumpmetallisierungsstruktur, UBM-Struktur (130), wobei die UBM-Struktur eine Keimstruktur (240), ein erstes leitfähiges Material (132) und ein zweites leitfähiges Material (134) umfasst,
wobei das Bilden der UBM-Struktur Folgendes umfasst:
Bilden einer Maske (250) auf der Keimstruktur, wobei die Maske eine Öffnung (252) aufweist, die einen Bereich der Keimstruktur, der elektrisch mit der Durchkontaktierung gekoppelt ist, freilegt;
Plattieren des ersten leitfähigen Materials (132) auf den freigelegten Bereich der Keimstruktur;
und Abscheiden des zweiten leitfähigen Materials (134) in die Öffnung über dem ersten leitfähigen Material; Bilden eines Kragens (138) aus einem benetzungshemmenden Material, wobei der Kragen einen Teil des gesamten Umfangs einer Seitenwand der UBM-Struktur umgibt, ohne eine obere Oberfläche der UBM-Struktur zu bedecken, und der Kragen sich entlang eines Teils einer Höhe der Seitenwand der UBM-Struktur erstreckt;
Anordnen eines Lotmaterials (140) auf der oberen Oberfläche der UBM-Struktur,
wobei das Lotmaterial in die Öffnung (252) auf der UBM-Struktur (130) und dem Kragen (138) plattiert wird, wobei das Lotmaterial das benetzungshemmende Material nicht ohne Weiteres benetzt, wenn das Lotmaterial in flüssiger Phase vorliegt;
Entfernen mindestens eines Teils der Maske, wodurch ein Teil der Keimstruktur freigelegt wird; und
Entfernen des freigelegten Teils der Keimstruktur durch Nassätzen.

2. Verfahren nach Anspruch 1, wobei das benetzungshemmende Material mindestens eines von Folgendem umfasst: einem Nitrid, einem Oxid oder Polyimid.

3. Verfahren nach Anspruch 1, wobei die Öffnung (252) in der Maske (250) einen oberen Teil und einen unteren Teil aufweist, wobei der obere Teil breiter als der untere Teil ist, wobei das Verfahren ferner Folgendes umfasst:
Plattieren des ersten leitfähigen Materials (132) in den unteren Teil der Öffnung;
Abscheiden des zweiten leitfähigen Materials (134) in den unteren Teil der Öffnung über dem ersten leitfähigen Material, wodurch die UBM-Struktur in dem unteren Teil gebildet wird;
Entfernen eines Teils der Maske, um eine die UBM-Struktur umgebende Kragenöffnung (158, 258) zu definieren; und
Bilden des Kragens (138), der das benetzungshemmende Material umfasst, in der Kragenöffnung (158, 258).

4. Verfahren nach Anspruch 3, wobei das Bilden des Kragens (138), der das benetzungshemmende Material umfasst, in der Kragenöffnung (158, 258) Folgendes umfasst:
Abscheiden einer flächendeckenden Schicht des benetzungshemmenden Materials über der Maske (250) und der Öffnung (252); und
Ätzen, um einen Teil des benetzungshemmenden Materials zu entfernen, während das benetzungshemmende Material in der Kragenöffnung belassen wird.

5. Verfahren zum Herstellen eines Halbleiterchips (120), wobei der Halbleiterchip ein Halbleitermaterial (110) mit Festkörperbauelementen und eine sich mindestens teilweise durch das Halbleitermaterial erstreckende Durchkontaktierung (124) umfasst;
wobei das Verfahren Folgendes umfasst:
Bilden eines Kragens (138) aus einem benetzungshemmenden Material, wobei das Bilden des Kragens Folgendes umfasst:
Bilden einer Maske (250) auf einer Keimstruktur (240), wobei die Maske eine erste Öffnung (252) aufweist, die einen Bereich der Keimstruktur, der elektrisch mit der Durchkontaktierung gekoppelt ist, freilegt; und
Bilden des Kragens über dem freigelegten Bereich der Keimstruktur, wobei der Kragen eine zweite Öffnung definiert;
Bilden einer Unterbumpmetallisierungsstruktur, UBM-Struktur (130), wobei die UBM-Struktur die Keimstruktur (240), ein erstes leitfähiges Material (132) und ein zweites leitfähiges Material (134) umfasst,
wobei das Bilden der UBM-Struktur Plattieren des ersten leitfähigen Materials (132) in die zweite Öffnung und Abscheiden des zweiten leitfähigen Materials (134) über dem ersten leitfähigen Material umfasst,
wobei der Kragen einen Teil des gesamten Umfangs einer Seitenwand der UBM-Struktur umgibt, ohne eine obere Oberfläche der UBM-Struktur zu bedecken,
und der Kragen sich entlang eines Teils einer Höhe der Seitenwand der UBM-Struktur erstreckt;
Anordnen eines Lotmaterials (140) auf der oberen Oberfläche der UBM-Struktur,
wobei das Lotmaterial in die Öffnung (252) auf der UBM-Struktur (130) und dem Kragen (138) plattiert wird, wobei das Lotmaterial das benetzungshemmende Material nicht ohne Weiteres benetzt, wenn das Lotmaterial in flüssiger Phase vorliegt;
Entfernen mindestens eines Teils der Maske, wodurch ein Teil der Keimstruktur freigelegt wird; und
Entfernen des freigelegten Teils der Keimstruktur durch Nassätzen.

6. Verfahren nach Anspruch 5, wobei das Bilden des Kragens (138) Folgendes umfasst:
Abscheiden einer flächendeckenden Schicht des benetzungshemmenden Materials über der Maske (250) und der ersten Öffnung (252), wobei das benetzungshemmende Material innere Seitenoberflächen der Öffnung beschichtet; und
Durchführen einer anisotropen Ätzung an dem benetzungshemmenden Material, um benetzungshemmendes Material von einer unteren Oberfläche der ersten Öffnung zu entfernen, wodurch die zweite Öffnung gebildet wird.

## Revendications

1. Procédé de fabrication d'une puce semi-conductrice (120), la puce semi-conductrice comprenant un matériau semi-conducteur (110) comportant des composants à l'état solide et une interconnexion (124) s'étendant au moins partiellement à travers le matériau semi-conducteur ; le procédé comprenant :
la formation d'une structure de métallisation sous bosse, UBM, (130), la structure UBM comprenant une structure germe (240), un premier matériau conducteur (132) et un deuxième matériau conducteur (134),
dans lequel la formation de la structure UBM comprend :
la formation d'un masque (250) sur la structure germe, le masque ayant une ouverture (252) qui expose une zone de la structure germe qui est électriquement couplée à l'interconnexion ;
le placage du premier matériau conducteur (132) sur la zone exposée de la structure germe ;
et le dépôt du deuxième matériau conducteur (134) dans l'ouverture par-dessus le premier matériau conducteur ; la formation d'un collier (138) à partir d'un matériau anti-mouillage, dans lequel le collier entoure une partie de la circonférence complète d'une paroi latérale de la structure UBM sans recouvrir la surface supérieure de la structure UBM, et le collier s'étend le long d'une partie d'une hauteur de la paroi latérale de la structure UBM ; la disposition d'un matériau de brasage (140) sur la surface supérieure de la structure UBM,
dans lequel le matériau de brasage est plaqué dans l'ouverture (252) par-dessus la structure UBM (130) et le collier (138),
dans lequel le matériau de brasage ne mouille pas facilement le matériau anti-mouillage lorsque le matériau de brasage est en phase liquide ;
l'élimination d'au moins une partie du masque, exposant ainsi une partie de la structure germe ; et l'élimination de la partie exposée de la structure germe par gravure humide.

2. Procédé selon la revendication 1, dans lequel le matériau anti-mouillage comprend au moins l'un des éléments suivants : un nitrure, un oxyde ou un polyimide.

3. Procédé selon la revendication 1 dans lequel l'ouverture (252) dans le masque (250) présente une partie supérieure et une partie inférieure, dans lequel la partie supérieure est plus large que la partie inférieure, le procédé comprenant en outre :
le placage du premier matériau conducteur (132) dans la partie inférieure de l'ouverture ;
le dépôt du deuxième matériau conducteur (134) dans la partie inférieure de l'ouverture par-dessus le premier matériau conducteur, formant ainsi la structure UBM dans la partie inférieure ;
l'élimination d'une partie du masque pour définir une ouverture de collier (158, 258) entourant la structure UBM ; et
la formation du collier (138) comprenant le matériau anti-mouillage dans l'ouverture de collier (158, 258).

4. Procédé selon la revendication 3, dans lequel la formation du collier (138) comprenant le matériau anti-mouillage dans l'ouverture de collier (158, 258) comprend :
le dépôt d'une couche de couverture du matériau anti-mouillage par-dessus le masque (250) et l'ouverture (252) ; et
une gravure pour éliminer une partie du matériau anti-mouillage tout en conservant du matériau anti-mouillage dans l'ouverture de collier.

5. Procédé de fabrication d'une puce semi-conductrice (120), la puce semi-conductrice comprenant un matériau semi-conducteur (110) comportant des composants à l'état solide et une interconnexion (124) s'étendant au moins partiellement à travers le matériau semi-conducteur ; le procédé comprenant :
la formation d'un collier (138) à partir d'un matériau anti-mouillage, la formation du collier comprenant : la formation d'un masque (250) sur une structure germe (240),
dans lequel le masque comporte une première ouverture (252) qui expose une zone de la structure germe qui est électriquement couplée à l'interconnexion ; et
la formation du collier par-dessus la zone exposée de la structure germe, le collier définissant une deuxième ouverture ;
la formation d'une structure de métallisation sous bosse, UBM, (130), la structure UBM comprenant la structure germe (240), un premier matériau conducteur (132) et un deuxième matériau conducteur (134),
dans lequel la formation de la structure UBM comprend le placage du premier matériau conducteur (132) dans la deuxième ouverture et le dépôt du deuxième matériau conducteur (134) par-dessus le premier matériau conducteur,
dans lequel le collier entoure une partie de la circonférence complète d'une paroi latérale de la structure UBM sans recouvrir une surface supérieure de la structure UBM,
et le collier s'étend le long d'une partie d'une hauteur de la paroi latérale de la structure UBM ;
la disposition d'un matériau de brasage (140) sur la surface supérieure de la structure UBM,
dans lequel le matériau de brasage est plaqué dans l'ouverture (252) par-dessus la structure UBM (130) et le collier (138),
dans lequel le matériau de brasage ne mouille pas facilement le matériau anti-mouillage lorsque le matériau de brasage est en phase liquide ;
l'élimination d'au moins une partie du masque, exposant ainsi une partie de la structure germe ; et
l'élimination de la partie exposée de la structure germe par gravure humide.

6. Procédé selon la revendication 5, dans lequel la formation du collier (138) comprend :
le dépôt d'une couche de couverture du matériau anti-mouillage par-dessus le masque (250) et la première ouverture (252), le matériau anti-mouillage recouvrant les surfaces latérales intérieures de l'ouverture ; et
la réalisation d'une gravure anisotrope sur le matériau anti-mouillage pour éliminer du matériau anti-mouillage d'une surface inférieure de la première ouverture, formant ainsi la deuxième ouverture.
